# EUROPEAN PATENT APPLICATION

(11) **EP 3 480 912 A1**
(43) Date of publication of application: **08.05.2019**
(21) Application number: 17819743.0
(22) Date of filing: 30.05.2017
(51) Int. Cl.: H02H 7/20, H02H 7/00, H03K 17/0814, H05B 37/02

(54) **PROTECTION CIRCUIT AND WIRING DEVICE**

(30) Priority: 30.06.2016 JP 2016131045
(71) Applicant: Panasonic Intellectual Property Management Co., Ltd., Osaka-shi, Osaka 540-6207 (JP)
(72) Inventor: NAKAMURA, Masayuki, Osaka 540-6207 (JP); MIYAKE, Tomohiro, Osaka 540-6207 (JP); GOTO, Kiyoshi, Osaka 540-6207 (JP); MIYAMOTO, Kengo, Osaka 540-6207 (JP)
(74) Representative: Appelt, Christian W.
(86) International application number: PCT/JP2017/020087
(87) International publication number: WO 2018/003376

(57) **Abstract**

Object of present invention is to provide protective circuit and wiring accessory, capable of protecting switch circuit when AC power grid is connected between both ends of switch circuit with load not interposed. Protective circuit (1) is provided for wiring accessory (10) including switch circuit (2) and switch controller (61). Switch circuit (2) possesses control terminal, and is electrically connected between input terminals (TM1, TM2) that allow electrical connection to both ends of series circuit of AC power grid (8) and load (7), and is switched between conductive and non-conductive between both ends of series circuit according to control signal to control terminal. Protective circuit (1) includes current sensor (110) that detects electric current (I1) flowing through switch circuit (2), and protective switch (120) that is electrically connected between control terminal and potential reference point, and turns on when current value of electric current (I1) detected through current sensor (110) exceeds threshold value.

## Description

### Technical Field

The invention relates generally to protective circuits and wiring accessories and, more particularly, to a protective circuit and a wiring accessory each of which is configured to protect a switch device electrically connected between two input terminals that allow electrical connection to both ends of a series circuit of an alternating-current (AC) power grid and a load.

### Background Art

There has been provided a related dimmer configured to control a light output of a lighting load (e.g., see Patent Document 1). The dimmer described in Patent Document 1 includes a semiconductor switch device, a dimming control circuit, an overcurrent detector circuit and two terminals. The dimming control circuit is configured to perform a conduction or phase angle control of the semiconductor switch device. The overcurrent detector circuit is configured to detect an overcurrent flowing through the semiconductor switch device. The semiconductor switch device is connected between the two terminals, while a series circuit of the lighting load and mains electricity is to be connected between the two terminals.

With the dimmer described in Patent Document 1, when the overcurrent detector circuit detects an overcurrent flowing through the semiconductor switch device, the dimming control circuit limits a dimming ratio of the lighting load to a predetermined dimming ratio or less. As a result, an electric current flowing through the semiconductor switch device is adjusted to equal to or less than a rated current of the semiconductor switch device.

In a dimmer (wiring accessory) as described in Patent Document 1, there is a possibility that the semiconductor switch device (switch circuit) will be damaged as a result of a contractor connecting the mains electricity between the two terminals erroneously without interposing the lighting load therebetween.

### Citation List

### Literature

Patent Document 1: JP 2001-307890 A

### Summary of Invention

The present invention has been achieved in view of the above circumstances, and an object thereof is to provide a protective circuit and a wiring accessory, capable of protecting a switch circuit when an AC power grid is connected between both ends of the switch circuit with a load not interposed therebetween.

A protective circuit according to an aspect of the present invention is provided for a wiring accessory including a switch circuit and a switch controller. The switch circuit possesses a control terminal, and is electrically connected between a first input terminal and a second input terminal that allow electrical connection to both ends of a series circuit of an AC power grid and a load, and is configured to, according to a control signal to the control terminal, be switched between conductive and non-conductive between both the ends of the series circuit. The switch controller is configured to control the switch circuit. The protective circuit includes a current sensor and a protective switch. The current sensor is configured to detect an electric current flowing through the switch circuit. The protective switch is to be electrically connected between the control terminal and a potential reference point, and is configured to turn on when a current value of the electric current detected through the current sensor exceeds a threshold value.

A wiring accessory according to an aspect of the present invention includes the protective circuit, the switch circuit and the switch controller. The switch circuit possesses the control terminal, and is electrically connected between the first input terminal and the second input terminal that allow the electrical connection to both the ends of the series circuit of the AC power grid and the load, and is configured to, according to the control signal to the control terminal, be switched between conductive and non-conductive between both the ends of the series circuit. The switch controller is configured to control the switch circuit.

### Brief Description of Drawings

FIG. 1 is a schematic circuit diagram showing a configuration of a protective circuit and a wiring accessory according to an embodiment of the present invention; and
FIG. 2 is a timing diagram representing protective act of the protective circuit.

### Description of Embodiments

A protective circuit and a wiring accessory according to an embodiment of the present invention will hereinafter be explained with reference to the drawings. However, as a configuration to be explained below is merely one example of the present invention, the present invention is not limited to the embodiment below. Various modifications are possible in light of general arrangement and the like and may be made regardless of the embodiment without departing from the scope of technical ideas according to the present invention.

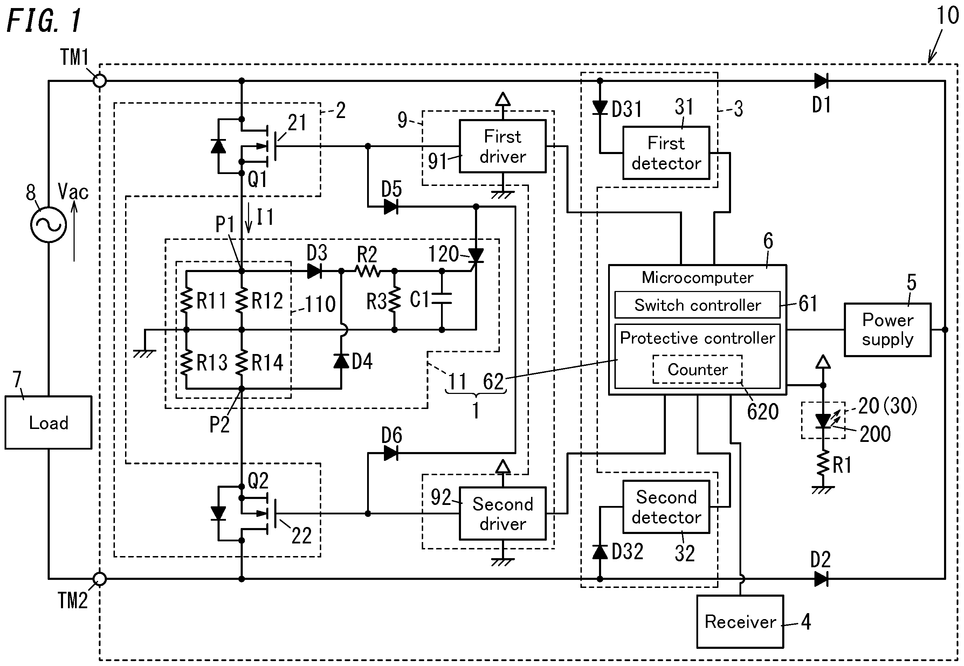

A wiring accessory 10 according to the embodiment is, for example two-wire dimmer device (hereinafter also referred to as a "dimmer device 10"), and allows electrical connection to an AC power grid 8 with the dimmer device electrically connected in series to a load 7 as shown in FIG. 1. For example, the load 7 is a lighting load and includes a light emitting diode(s) (LED(s)) as a light source and lighting circuitry configured to cause the LED(s) to light. The AC power grid 8 is, for example mains electricity, single phase 220 [V], 50 [Hz]. As an example, the dimmer device 10 is applicable to a wall switch and the like.

As shown in FIG. 1, the dimmer device 10 includes a protective circuit 1, a switch circuit 2, a phase detector 3, a receiver 4, a power supply 5, a microcomputer 6, a switch driver 9, a display 20 and two input terminals TM1 and TM2. In the present embodiment, the input terminal TM1 is a first input terminal, while the input terminal TM2 is a second input terminal.

The switch circuit 2 is to be electrically connected between both ends of a series circuit of the AC power grid 8 and the load 7, and is configured to be switched between conductive and non-conductive between both the ends of the series circuit of the AC power grid 8 and the load 7. For example, the switch circuit 2 possesses first and second switch devices Q1 and Q2 (hereinafter referred to as "switch devices Q1 and Q2") that are electrically connected in series between the two input terminals TM1 and TM2. Each of the switch devices Q1 and Q2 is, for example a semiconductor switch device composed of an enhancement type n-channel metal-oxide-semiconductor field effect transistor (MOSFET).

The switch devices Q1 and Q2 are electrically connected in series so as to allow an electric current (I1) to flow in one direction reversed when being turned off (what is called anti-series connection). In the present embodiment, as shown in FIG. 1, the switch Q1 allows an electric current I1 to flow in a direction from the input terminal TM2 to the input terminal TM1 when being turned off, while the switch device Q2 allows an electric current I1 to flow in a direction from the input terminal TM1 to the input terminal TM2 when being turned off. That is, respective sources of the switch devices Q1 and Q2 are connected to each other via a current sensor 110 to be described later. A drain of the switch device Q1 is connected to the input terminal TM1, while a drain of the switch device Q2 is connected to the input terminal TM2. The sources of the switch devices Q1 and Q2 are connected to ground of the power supply 5 via the current sensor 110. A gate 21 (control terminal) of the switch device Q1 is electrically connected to an output terminal of a first driver 91 to be described later, while a gate 22 (control terminal) of the switch device Q2 is electrically connected to an output terminal of a second driver 92 to be described later. Note that the ground of the power supply 5 becomes a potential reference point for internal circuits of the wiring accessory 10.

The phase detector 3 is configured to detect a phase of AC voltage Vac applied across the input terminals TM1 and TM2. The "phase" stated herein includes zero crossings of the AC voltage Vac and (positive, negative) polarity of the AC voltage Vac. In the present embodiment, the phase detector 3 is configured to detect a zero crossing of the AC voltage Vac and then provide the microcomputer 6 with a detection signal. The phase detector 3 may possess a diode D31, a first detector 31, a diode D32 and a second detector 32. The first detector 31 is electrically connected to the input terminal TM1 via the diode D31. The second detector 32 is electrically connected to the input terminal TM2 via the diode D32. The first detector 31 is configured to detect a zero crossing every transition from a negative half period to a positive half period of the AC voltage Vac. The second detector 32 is configured to detect a zero crossing every transition from a positive half period to a negative half period of the AC voltage Vac.

Specifically, the first detector 31 may detect a zero crossing whenever detecting a transition from a state in which voltage with the input terminal TM1 rendered positive is less than a reference threshold to a state in which it is equal to or greater than the reference threshold. Similarly, the second detector 32 may detect a zero crossing whenever detecting a transition from a state in which voltage with the input terminal TM2 rendered positive is less than a reference threshold to a state in which it is equal to or greater than the reference threshold. Each of the reference thresholds is a value (absolute value) around 0 [V]. For example, the reference threshold for the first detector 31 is + several volts, while the reference threshold for the second detector 32 is - several volts. Accordingly, respective time points of zero crossings detected through the first and second detectors 31 and 32 are slightly delayed from respective zero crossings (0 [V]) in a strict sense.

The receiver 4 is configured to receive a signal representing a dimming level or a light output level from a console to be operated by a user to provide the microcomputer 6 with the received signal as a dimming signal. The receiver 4 may process the received signal to output the dimming signal, or output the dimming signal without processing the received signal. The dimming signal represents a numerical value or the like corresponding to a light output level of the load 7, and may contain an "OFF level" for turning the load 7 off. Note that the console may be configured to receive an operation by a user to provide the receiver 4 with a signal representing a dimming level. Examples thereof include a variable resistor, a rotary switch, a rotary encoder, a touch panel, a remote controller, and a communication terminal such as smartphone.

The microcomputer 6 possesses a switch controller 61 and a protective controller 62. The switch controller 61 is configured to control the switch circuit 2 based on detection signals from the phase detector 3 (respective detection signals from the first and second detectors 31 and 32) and a dimming signal from the receiver 4. The switch controller 61 may individually control the switch devices Q1 and Q2. Specifically, the switch controller 61 may control the switch device Q1 according to a first drive signal, and control the switch device Q2 according to a second drive signal. The protective controller 62 will be described later.

The microcomputer 6 is configured to cause a central processing unit (CPU) thereof to execute a program stored in a memory thereof, thereby realizing respective functions of the switch controller 61 and the protective controller 62. In this example, although the program to be executed by the CPU is stored in the memory of the microcomputer 6 in advance, the program may be stored in a non-transitory storage medium such as a memory card to be provided, or may be provided via telecommunications network such as the Internet.

The switch driver 9 possesses the first driver 91 and the second driver 92. The first driver 91 is configured to drive (turn on and off) the switch device Q1. The second driver 92 is configured to drive (turn on and off) the switch device Q2. The first driver 91 may receive a first drive signal from the switch controller 61 to apply gate voltage to the switch device Q1. Thus, the first driver 91 will turn the switch device Q1 on and off. Similarly, the second driver 92 may receive a second drive signal from the switch controller 61 to apply gate voltage to the switch device Q2. Thus, the second driver 92 will turn the switch device Q2 on and off.

The power supply 5 is electrically connected to the input terminal TM1 via the diode D1, and also electrically connected to the input terminal TM2 via the diode D2. Here, two diodes D1 and D2 and respective body diodes of the two switch devices Q1 and Q2 constitute a diode bridge. The diode bridge will accordingly full-wave rectify the AC voltage Vac applied across the input terminals TM1 and TM2 to supply the full-wave rectified AC voltage to the power supply 5. The power supply 5 may smooth the full-wave rectified AC voltage Vac to produce a drive power supply and a control power supply. The drive power supply may provide electric power of, e.g., 10 [V] for energizing the switch driver 9. The control power supply may provide electric power of, e.g., 3 [V] for energizing the microcomputer 6.

The display 20 possesses a light source 200 configured to be turned on and off according to an operating state of the dimmer device 10. The light source 200 includes, for example an LED device. An anode of the LED device is electrically connected to the microcomputer 6 and a high potential side of the drive power supply in the power supply 5. A cathode of the LED device is electrically connected to a low potential side (ground) of the drive power supply via a resistor R1. The display 20 is configured to turn the light source 200 on and off according to a signal from the microcomputer 6. Specifically, the display 20 may be configured to turn the light source 200 on when the load 7 is turned off by OFF of the dimmer device 10, and turn the light source 200 off when the load 7 is lighting at a predetermined dimming level by ON of the dimmer device 10, Thus, it is possible to indicate an operating state of the dimmer device 10 to a user.

Note that the lighting circuitry in the load 7 is configured to read a dimming level from waveform of the AC voltage Vac phase-controlled by the dimmer device 10 to vary a light output level of the LED device. Here, as an example, the lighting circuitry possesses a circuit configured to secure an electric current, such as a bleeder circuit. The dimmer device 10 accordingly allows an electric current to flow through the load 7 even when the switch circuit 2 of the dimmer device 10 is non-conductive.

A dimming operation of the dimmer device 10 according to the present embodiment will next be explained. In the explanation below, a control method of the switch controller 61 for the switch circuit 2 to be exemplified is what is called a reverse phase control method (trailing edge method).

An operation of the dimmer device 10 during a positive half period of the AC voltage Vac will be first explained. When the first detector 31 detects a zero crossing during a transition from a negative half period to a positive half period of the AC voltage Vac, the switch controller 61 provides the first driver 91 with a first drive signal to turn the switch device Q1 on. A conduction time according to a dimming signal from the receiver 4 elapses, and the switch controller 61 then turns the switch device Q1 off. During the ON period of the switch device Q1, the turned-on switch device Q1 conducts, and closes between the two input terminals TM1 and TM2 along with the body diode of the switch device Q2 that is OFF.

An operation of the dimmer device 10 during a negative half period of the AC voltage Vac will next be explained. When the second detector 32 detects a zero crossing during a transition from a positive half period to a negative half period of the AC voltage Vac, the switch controller 61 provides the second driver 92 with a second drive signal to turn the switch device Q2 on. A conduction time according to the dimming signal from the receiver 4 elapses, and the switch controller 61 then turns the switch device Q2 off. During the ON period of the switch device Q2, the turned-on switch device Q2 conducts, and closes between the two input terminals TM1 and TM2 along with the body diode of the switch device Q1 that is OFF.

As explained above, the dimmer device 10 according to the present embodiment alternately repeats the operation of the positive half period and the operation of the negative half period every half period of the AC voltage Vac, thereby performing a light output control of the load 7.

Here, a correct installation of the abovementioned dimmer device 10 is performed by connecting the AC power grid 8 between the two input terminals TM1 and TMs via the load 7. There is however a possibility that a contractor will connect the AC power grid 8 between the two input terminals TM1 and TM2 erroneously without interposing the load 7 therebetween. The dimmer device 10 is accordingly configured to protect the switch devices Q1 and Q2 even when a contractor connects the AC power grid 8 between the two input terminals TM1 and TM2 erroneously without interposing the load 7 therebetween. The dimmer device 10 according to the present embodiment is provided with a protective circuit 1 configured to protect the switch devices Q1 and Q2. Hereinafter, the protective circuit 1 will be explained in detailed.

As shown in FIG. 1, the protective circuit 1 includes an overcurrent protector 11, the protective controller 62 and an indicator 30. The overcurrent protector 11 possesses the current sensor 110 and a protective switch 120.

As shown in FIG. 1, the current sensor 110 is composed of four resistors R11 to R14. The current sensor 110 is electrically connected between the respective sources of the switch devices Q1 and Q2. That is, the current sensor 110 is configured to detect an electric current I1 flowing between the switch devices Q1 and Q2. The current sensor 110 possesses a series circuit of the resistors R11 and R13, and a series circuit of the resistors R12 and R14. The ground of the power supply 5 is connected with a junction at which respective first ends of the resistors R11 and R13 are connected and a junction at which respective first ends of the resistors R12 and R14. The drain of the switch device Q1 is connected to the input terminal TM1, while the source of the switch device Q1 is connected to respective second ends of the resistor R11 and R12. The drain of the switch device Q2 is connected to the input terminal TM2, while the source of the switch device Q2 is connected to respective second ends of the resistors R13 and R14. That is, the resistors R11 and R12 and the resistors R13 and R14 are connected between the two switch devices Q1 and Q2 to be symmetrical with respect to the ground of the power supply 5. During each positive half period of the AC voltage Vac, an overcurrent is detected through the resistors R11 and R12 and then the protective switch 120 turns on. During each negative half period of the AC voltage Vac, an overcurrent is detected through the resistors R13 and R14 and then the protective switch 120 turns on. In the present embodiment, each of the resistors R11 and R12 corresponds to a first resistor, while each of the resistors R13 and R14 corresponds to a second resistor.

The protective switch 120 is, for example a thyristor. An anode of the thyristor is electrically connected to the gate 21 (control terminal) of the switch device Q1 via a diode D5, and also electrically connected to the gate 22 (control terminal) of the switch device Q2 via a diode D6. A cathode of the thyristor is electrically connected to the ground of the power supply 5. That is, in the present embodiment, the ground of the power supply 5 serves as the potential reference point. A gate of the thyristor is electrically connected to a junction P1 of the source of the switch device Q1 and both the resistors R11 and R12 via a resistor R2 and a diode D3. The gate of the thyristor is also electrically connected to a junction P2 of the source of the switch device Q2 and both the resistors R13 and R14 via the resistor R2 and a diode D4. The resistor R3 and a capacitor C1 are electrically connected between the cathode and the gate of the thyristor.

As stated above, the CPU executes the program stored in the memory of the microcomputer 6, so that the protective controller 62 is realized. The protective controller 62 possesses a counter 620. The counter 620 is configured to count the number of times a current value exceeds a threshold value, where the current value is a value of an electric current I1 flowing through the switch devices Q1 and Q2. In other words, the number of times an overcurrent (short-circuit current) flows through the switch devices Q1 and Q2 is counted. In the state where no overcurrent flows through the switch devices Q1 and Q2, the protective switch 120 is OFF and therefore electric potential at the anode of the protective switch 120 is equal to electric potential at the high potential side of the drive power supply in the power supply 5. On the other hand, when an overcurrent flows through the switch devices Q1 and Q2, the protective switch 120 turns on and the electrical potential at the anode of the protective switch 120 becomes equal to electric potential at the ground of the power supply 5. The counter 620 is monitoring the electric potential at the anode of the protective switch 120. The counter 620 counts the number of times the electrical potential at the anode of the protective switch 120 accords with electric potential at the ground of the power supply 5, thereby counting the number of times an overcurrent flows through the switch devices Q1 and Q2. When a value counted by the counter 620 reaches a specified value (e.g., ten or ten times), the protective controller 62 causes the switch controller 61 to control the switch circuit 2 so that it is rendered non-conductive between the AC power grid 8 and the load 7 is maintained. In other words, when the value counted by the counter 620 reaches the specified value, the protective controller 62 causes the switch controller 61 to turn the switch devices Q1 and Q2 off.

After the non-conductive state is maintained between the AC power grid 8 and the load 7 as stated above, a breaker is turned off, for example and the power supply from the AC power grid 8 to the dimmer device 10 is stopped, so that the value counted by the protective controller 62 (counter 620) is reset. Thus, the non-conductive state between the AC power grid 8 and the load 7 is cancelled. If the wrong wiring is not eliminated, the malfunction (overcurrent) is detected again, and the counter 620 then counts the number of times as above. When a value counted by the counter 620 reaches the specified value, a non-conductive state is maintained between the AC power grid 8 and the load 7. On the other hand, if the wrong wiring is eliminated by a contractor (the wiring is corrected), dimming control is possible according to a dimming level when the wiring accessory 10 is a dimmer device. As described below, when the wiring accessory 10 is a regulator, speed adjusting control is possible according to setting of the regulator. That is, in the dimmer device 10 according to the present embodiment, when the power supply from the AC power grid 8 is stopped and then the value counted by the counter 620 is reset, the protective controller 62 causes the switch controller 61 to control the switch circuit 2 so that it is not rendered non-conductive between the AC power grid 8 and the load 7.

In the dimmer device 10 according to the present embodiment, during a positive half period of the AC voltage Vac, a current value of an electric current I1 flowing through the switch devices Q1 and Q2 exceeds the corresponding threshold value. Furthermore, during a negative half period of the AC voltage Vac, the current value of the electric current I1 exceeds the corresponding threshold value. In other words, during one period of the AC voltage Vac, the current value of the electric current I1 exceeds respective thresholds once each. Therefore, when the value counted by the counter 620 corresponds to five periods of the AC voltage Vac, the protective controller 62 causes the switch controller 61 to control the switch circuit 2 so that it is rendered non-conductive between the AC power grid 8 and the load 7. Note that in the dimmer device 10 according to the present embodiment, the AC power grid 8 continues applying the AC voltage Vac until it is interrupted caused by, for example an electrical power failure or the like, and therefore the value counted by the counter 620 is to be reset as a result of an electrical power failure of the AC power grid 8.

The indicator 30 is configured to indicate at least one of a state (hereinafter referred to as a "first state") in which the current value of the electric current I1 flowing through the switch devices Q1 and Q2 exceeds the respective threshold values and a state (hereinafter referred to as a "second state") in which the value counted by the counter 620 reaches the specified value. In the present embodiment, the abovementioned display 20 of the dimmer device 10 doubles as the indicator 30. The indicator 30 is configured to blink according to a signal from the protective controller 62. For example, when the protective controller 62 determines the presence of the first state, the indicator 30 causes the light source 200 to blink at predetermined intervals (e.g., intervals of one second) according to the signal from the protective controller 62. When the protective controller 62 determines the presence of the second state, the indicator 30 causes the light source 200 to blink at intervals (e.g., intervals of half a second) different from the intervals in the first state according to the signal from the protective controller 62. This enables the indicator 30 to indicate to a user that the dimmer device 10 is in at least one of the first and second states. The display 20 of the wiring accessory 10 doubles as the indicator 30, thereby enabling reduction in the number of components as compared with the case where the indicator 30 is separately provided.

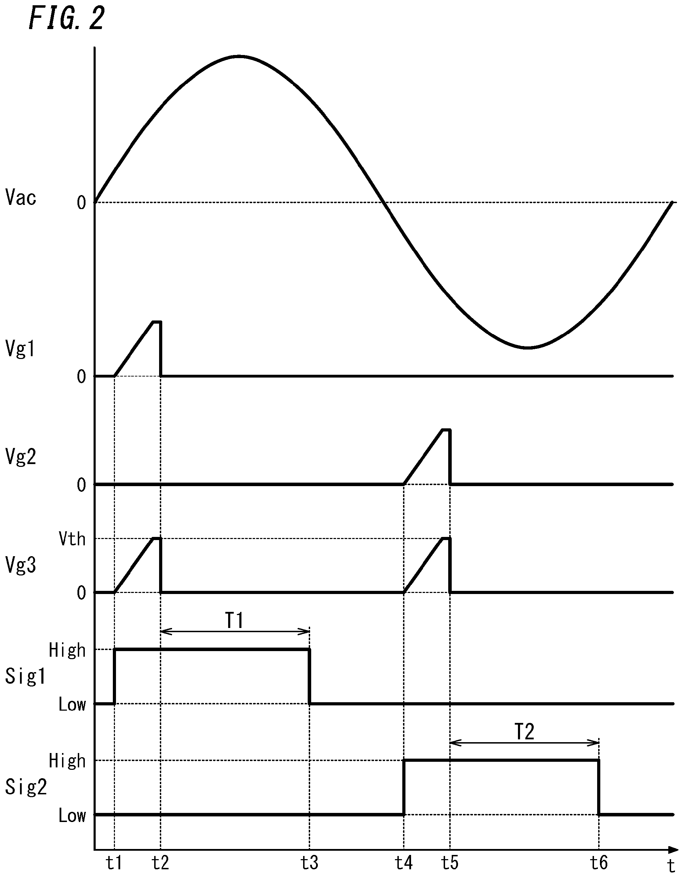

Hereinafter, a protective operation of the protective circuit 1 will be explained in detail with reference to FIG. 2. FIG. 2 is a timing diagram representing one period of the AC voltage Vac from the AC power grid 8. The "Vg1" in FIG. 2 represents gate voltage applied to the gate 21 of the switch device Q1. The "Vg2" in FIG. 2 represents gate voltage applied to the gate 22 of the switch device Q2. The "Vg3" in FIG. 2 represents gate voltage applied to the gate of the protective switch 120. The "Sig1" in FIG. 2 represents the first drive signal from the switch controller 61 to the first driver 91. The "Sig2" in FIG. 2 represents the second drive signal from the switch controller 61 to the second driver 92.

At time t1, the polarity of the AC voltage Vac is positive, and therefore the switch controller 61 in the microcomputer 60 provides the first driver 91 with a HIGH level signal as the first drive signal Sig1. The first driver 91 receives the HIGH level signal as the first drive signal Sig1 to apply gate voltage Vg1 to the gate 21 of the switch device Q1. At this moment, the first driver 91 proportionately increases the gate voltage Vg1 from time t1 to time t2 to turn the switch device Q1 on. In addition, gate voltage Vg3 having waveform like the gate voltage Vg1 is applied to the gate of the protective switch 120 from time t1 to time t2. Here, the gate voltage Vg3 is electric potential at the junction P1 between the switch device Q1 and both the resistors R11 and R12.

At time t2, a voltage value of the gate voltage Vg3 reaches the threshold Vth and the protective switch 120 turns on. When the protective switch 120 turns on, a charge stored in the gate 21 of the switch device Q1 is discharged to the protective switch 120 via the diode D5. As a result, the gate voltage Vg1 becomes 0 [V] and the switch device Q1 is turned off. When the switch device Q1 is turned off, an electric current I1 flowing through the switch circuit 2 becomes 0 [A], while the gate voltage Vg3 also becomes 0 [V].

At time t2, although the gate voltage Vg3 also becomes 0 [V], an electric current continues flowing through the protective switch 120 because the first drive signal Sig1 is a HIGH level signal up to time t3. The protective switch 120 is accordingly kept in ON state during a time period T1 from time t2 to time t3 while the gate voltage Vg3 is 0 [V], and the switch device Q1 is also kept in OFF state. At time t3, the first drive signal Sig1 changes from a HIGH level to a LOW level, and then the protective switch 120 turns off because the gate voltage Vg2 is 0 [V].

At time t4, the polarity of the AC voltage Vac is negative, and therefore the switch controller 61 provides the second driver 92 with a HIGH level signal as the second drive signal Sig2. The second driver 92 receives the HIGH level signal as the second drive signal Sig2 to apply gate voltage Vg2 to the gate 22 of the switch device Q2. At this moment, the second driver 92 proportionately increases the gate voltage Vg2 from time t4 to time t5 to turn the switch device Q2 on. In addition, gate voltage Vg3 having waveform like the gate voltage Vg2 is applied to the gate of the protective switch 120 from time t4 to time t5. Here, the gate voltage Vg3 is electric potential at the junction P2 between the switch device Q2 and both the resistors R13 and R14.

At time t5, a voltage value of the gate voltage Vg3 reaches the threshold value Vth and the protective switch 120 turns on. When the protective switch 120 turns on, a charge stored in the gate 22 of the switch device Q2 is discharged to the protective switch 120 via the diode D6. As a result, the gate voltage Vg2 becomes 0 [V] and the switch device Q2 is turned off. When the switch device Q2 is turned off, an electric current I1 flowing through the switch circuit 2 also becomes 0 [A], while the gate voltage Vg3 also becomes 0 [V].

At time t5, although the gate voltage Vg3 also becomes 0 [V], an electric current continues flowing through the protective switch 120 because the second drive signal Sig2 is a HIGH level signal up to time t6. The protective switch 120 is accordingly kept in ON state during a time period T2 from time t5 to time t6 while the gate voltage Vg3 is 0 [V], and the switch device Q2 is also kept in OFF state. At time t6, the second drive signal Sig2 changes from a HIGH level to a LOW level, and then the protective switch 120 turns off because the gate voltage Vg3 is 0 [V].

The present embodiment enables the protective circuit 1 to repeat the operation during one period of the AC voltage explained above. That is, the protective circuit 1 is configured to return to an initial state every one period of the AC voltage Vac. The protective circuit 1 according to the present embodiment is configured to, when a value counted by the counter 620 reaches the specified value, maintain a non-conductive state between the AC power grid 8 and the load 7.

In the protective circuit 1 according to the present embodiment, the resistors R11 and R12 are provided at a side of the switch device Q1 and connected to the ground of the power supply 5, while the resistors R13 and R14 are provided at a side of the switch device Q2 and connected thereto. This enables even the single protective switch 120 to detect an overcurrent over one period of the AC voltage Vac.

Here, in the state where the AC power grid 8 is connected between the input terminals TM1 and TM2 with the load 7 not interposed therebetween, an electric current I1 flowing through the switch circuit 2 when either the switch device Q1 or the switch device Q2 is turned on is preferably equal to or less than each of respective rated currents of turned-on switch devices Q1 and Q2. In other words, respective resistance values of the resistors R11 to R14 are preferably set so that an electric current I1 flowing through the switch circuit 2 is equal to or less than each of the respective rated currents of the turned-on switch devices Q1 and Q2. It is accordingly possible to protect the switch circuit 2 even when the AC power grid 8 is connected between the input terminals TM1 and TM2 with the load 7 not interposed therebetween. There is also an advantage that the switch devices Q 1 and Q 2 are hardly damaged.

Modified examples of the present embodiment will hereinafter be explained.

Although the wiring accessory 10 according to the embodiment stated above is exemplified as the dimmer device, the wiring accessory 10 is not limited to the dimmer device. For example, a regulator configured to adjust a speed of an electric motor may be provided. In this case, examples of the load 7 include a ventilator and a circulator each of which includes an electric motor as a power source. That is, the load 7 is not limited to the lighting load. In addition, examples of the wiring accessory 10 may include an electronic switch such as, for example a timer.

Although the switch circuit 2 according to the embodiment stated above is composed of the two switch devices Q1 and Q2 electrically connected in anti-series connection, the switch circuit 2 may be composed of, for example a double-gate switch device. In this case, the switch device is preferably a semiconductor device with double-gate (dual-gate) structure made of wide band gap semiconductor material such as, for example gallium nitride (GaN). In addition, the switch circuit 2 preferably includes two diodes connected in what is called anti-parallel connection between the input terminals TM1 and TM2. This configuration enables reduction in conduction loss as compared with the case where the switch circuit 2 is composed of the two switch devices Q1 and Q2.

In the embodiment stated above, although a control method of the microcomputer 6 for the switch circuit 2 is exemplified as a reverse phase control method, the control method for the switch circuit 2 is not limited to the reverse phase control method, but may be a forward phase control method (leading edge method). In this case, a conductive state is maintained between the two input terminals TM1 and TM2 during a time period from an intermediate time to zero crossing of each half period of the AC voltage Vac.

In the embodiment stated above, although the specified value for the value counted by the counter 620 is exemplified as "10", the specified value is not limited to "10" if the configuration with no false detection caused by inrush current or the like is provided. That is, the specified value may be in a range of two to nine, or equal to or greater than eleven.

The dimming signal from the receiver 4 may contain the "OFF level" for turning the load 7 off and not contain the "OFF level". Preferably, a mechanical switch configured to turn the load 7 off, such as a push switch is further provided when the dimming signal contains no "OFF level". In this case, the value counted by the counter 620 is preferably reset when the mechanical switch turns the load 7 off.

Each of the two switch devices Q1 and Q2 constituting the switch circuit 2 is not limited to an enhancement type n-channel MOSFET, but examples thereof may include an insulated gate bipolar transistor (IGBT) and the like. In addition, the protective switch 120 is not limited to the thyristor, but examples thereof may include an IGBT, a MOSFET and the like.

Rectifying devices (diodes) for realizing unidirectional conduction included in the switch circuit 2 are not limited to the body diodes of the switch devices Q1 and Q2, but may be discrete diodes. In this case, the diodes may be built in the same package along with the switch devices Q1 and Q2.

In the embodiment stated above, although the switch controller 61 and the protective controller 62 are composed of the single microcomputer 6, the switch controller and the protective controller may be individually composed of their respective microcomputers.

In a comparison of a current value of an electric current I1 flowing through the switch circuit 2 with the threshold value, the current value of the electric current I1 exceeding the threshold value may include the current value of the electric current I1 equaling the threshold value. That is, "exceeding" may be synonymous with "equal to or greater than". That is, there is no technical difference between "exceeding" and "equal to or greater than" because whether or not the current value of the electric current I1 equaling the threshold value is included depends on setting and may be changed arbitrarily.

In the embodiment stated above, although the indicator 30 is configured to indicate both the first state and the second state, the indicator 30 may be configured to indicate at least one of the first and second states.

In the embodiment stated above, the current sensor 110 possesses, as the first resistor, the two resistors R11 and R12 and, as the second resistor, the two resistors R13 and R14, but may possess at least one resistor each as the first and second resistors.

### (Brief)

As is clear from the embodiment described above, a protective circuit (1) according to a first aspect is provided for a wiring accessory (10) equipped with a switch circuit (2) and a switch controller (61). The switch circuit (2) includes a control terminal (gate (21, 22)) and is electrically connected between a (first) input terminal (TM1) and a (second) input terminal (TM2) that allow electrical connection to both ends of a series circuit of an AC power grid (8) and a load (7). The switch circuit (2) is also configured to, according to a control signal to the control terminal, be switched between conductive and non-conductive between both the ends of the series circuit of the AC power grid (8) and the load (7). The switch controller (61) is configured to control the switch circuit (2). The protective circuit (1) includes a current sensor (110) and a protective switch (120). The current sensor (110) is configured to detect an electric current (I1) flowing through the switch circuit (2). The protective switch (120) is to be electrically connected between the control terminal and a potential reference point (in the present embodiment, ground of power supply (5)), and is configured to turn on when a current value of the electric current (I1) detected through the current sensor (110) exceeds a threshold value.

With the first aspect, when a current value of an electric current (I1) flowing through the switch circuit (2) exceeds the threshold value, the protective switch (120) turns on to interrupt the supply of the control signal to the control terminal of the switch circuit (2). As a result, the switch circuit (2) is stopped from being switched between conductive and non-conductive between both the ends of the series circuit of the AC power grid (8) and the load (7), thereby stopping the flow of the electric current (I1) through the switch circuit (2). It is therefore possible to protect the switch circuit (2) even when, for example, a contractor connects the AC power grid (8) between both the ends of the switch circuit (2) erroneously without interposing the load (7) therebetween.

In a protective circuit 1 according to a second aspect turning on the first aspect, the switch circuit (2) possesses a first switch device (Q1) and a second switch device (Q2) that are electrically connected in anti-series connection. The protective switch (120) is electrically connected between the potential reference point and, as the control terminal, both respective first and second control terminals (gates (21, 22)) of the first and second switch devices (Q1, Q2).

In the second aspect, the single protective switch (120) is connected with the first switch device (Q1) to be turned on every positive half period of AC voltage (Vac) and the second switch device (Q2) to turned on every negative half period thereof. This therefore enables the single protective switch (120) to reduce an overcurrent even when the overcurrent occurs over one period of the AC voltage (Vac). However, this configuration is not essential for the protective circuit (1). For example, separate protective switches may be individually connected to the first and second switch devices (Q1, Q2).

In a protective circuit (1) according to a third aspect turning on the second aspect, the current sensor (110) possesses at least a first resistor (R11, R12) which, with a first end of the first switch device (Q1) electrically connected to the (first) input terminal (TM1), is electrically connected between the potential reference point and a second end of the first switch device (Q1). The current sensor further includes at least a second resistor (R13, R14) which, with a first end of the second switch device (Q2) electrically connected to the (second) input terminal (TM1), is electrically connected between the potential reference point and a second end of the second switch device (Q2).

The third aspect enables even the single protective switch (120) to detect an overcurrent over one period of the AC voltage (Vac). However, this configuration is not essential for the protective circuit (1). The current sensor (110) need not necessarily have the first and second resistors.

A protective circuit (1) according to a fourth aspect turning on any of the first to third aspects further includes a protection controller (62). The protection controller (62) possesses a counter (620) configured to count the number of times the current value of the electric current (I1) flowing through the switch circuit (2) exceeds the threshold value. The protection controller (62) is configured to, when a value counted by the counter (620) reaches a specified value, cause the switch controller (61) to maintain a non-conductive state between both the ends of the series circuit of the AC power grid (8) and the load (7).

The fourth aspect makes it possible to reduce false detection caused by inrush current or the like because when the value counted by the counter (620) reaches the specified value, a non-conductive state is maintained between both the ends of the series circuit of the AC power grid (8) and the load (7). However, this configuration is not essential for the protective circuit (1). The protection controller (62) may be omitted.

A protective circuit (1) according to a fifth aspect turning on the fourth aspect further includes an indicator (30). The indicator (30) is configured to indicate at least one of a state in which the current value of the electric current (I1) flowing through the switch circuit (2) exceeds the threshold value and a state in which the value counted by the counter (620) reaches the specified value.

The fifth aspect makes it possible to indicate to a user that an overcurrent (short-circuit current) flows through the switch circuit (2). However, this configuration is not essential for the protective circuit (1). The indicator (30) may be omitted.

In a protective circuit (1) according to a sixth aspect turning on the fifth aspect, a display (20) doubles as the indicator (30). The display (20) possesses a light source (200) configured to turn on and off according to an operation state of the wiring accessory (10).

With the sixth aspect, it is unnecessary to separately provide the indicator (30), thereby enabling reduction of the number of components as compared with the case where the indicator (30) is separately provided. However, this configuration is not essential for the protective circuit (1). The indicator (30) may be provided separately with the display (20).

A wiring accessory (10) according to a seventh aspect includes a protective circuit (1) of any of the first to sixth aspects, the switch circuit (2) and the switch controller (61). The switch circuit (2) possesses the control terminal (gate (21, 22)) and is electrically connected between the (first) input terminal (TM1) and the (second) input terminal (TM2) that allow the electrical connection to both the ends of the series circuit of the AC power grid (8) and the load (7). The switch circuit (2) is configured to, according to the control signal to the control terminal, be switched between conductive and non-conductive between both the ends of the series circuit of the AC power grid (8) and the load (7). The switch controller (61) is configured to control the switch circuit (2).

This seventh aspect enables the protective circuit (1) to protect the switch circuit (2) when the AC power grid (8) is connected between both ends of the switch circuit (2) with the load (7) not interposed therebetween.

### Reference Signs List

- 1: Protective circuit
- 2: Switch circuit
- 7: Load
- 8: AC power grid
- 10: Wiring accessory
- 20: Display
- 21: Gate ((First) control terminal)
- 22: Gate ((Second) control terminal)
- 30: Indicator
- 61: Switch controller
- 62: Protection controller
- 110: Current sensor
- 120: Protective switch
- 200: Light source
- 620: Counter
- I1: Electric current
- Q1: First switch device
- Q2: Second switch device
- R11, R12: Resistor (First resistor)
- R13, R14: Resistor (Second resistor)
- TM1: Input terminal (First input terminal)
- TM2: Input terminal (Second input terminal)

## Claims

1. A protective circuit, for a wiring accessory comprising a switch circuit and a switch controller, the switch circuit including a control terminal, the switch circuit being electrically connected between a first input terminal and a second input terminal that allow electrical connection to both ends of a series circuit of an AC power grid and a load, the switch circuit being configured to, according to a control signal to the control terminal, be switched between conductive and non-conductive between both the ends of the series circuit, the switch controller being configured to control the switch circuit, wherein the protective circuit comprises
a current sensor configured to detect an electric current flowing through the switch circuit, and
a protective switch to be electrically connected between the control terminal and a potential reference point, the protective switch being configured to turn on when a current value of the electric current detected through the current sensor exceeds a threshold value.

2. The protective circuit of claim 1, wherein
the switch circuit includes a first switch device and a second switch device that are electrically connected in series so as to allow an electric current to flow in one direction reversed when being turned off, and
the protective switch is electrically connected between the potential reference point and, as the control terminal, both respective first and second control terminals of the first and second switch devices.

3. The protective circuit of claim 2, wherein the current sensor includes
at least a first resistor which, with a first end of the first switch device electrically connected to the first input terminal, is electrically connected between the potential reference point and a second end of the first switch device, and
at least a second resistor which, with a first end of the second switch device electrically connected to the second input terminal, is electrically connected between the potential reference point and a second end of the second switch device.

4. A protective circuit of any one of claims 1 to 3, further comprising a protection controller including a counter configured to count a number of times the current value exceeds the threshold value,
the protection controller being configured to, when a value counted by the counter reaches a specified value, cause the switch controller to maintain a non-conductive state between both the ends of the series circuit.

5. The protective circuit of claim 4, further comprising an indicator configured to indicate at least one of a state in which the current value exceeds the threshold value and a state in which the value counted by the counter reaches the specified value.

6. The protective circuit of claim 5, wherein a display doubles as the indicator, the display including a light source configured to turn on and off according to an operation state of the wiring accessory.

7. A wiring accessory, comprising
a protective circuit of any one of claims 1 to 6,
the switch circuit including the control terminal, the switch circuit being electrically connected between the first input terminal and the second input terminal that allow the electrical connection to both the ends of the series circuit of the AC power grid and the load, the switch circuit being configured to, according to the control signal to the control terminal, be switched between conductive and non-conductive between both the ends of the series circuit, and
the switch controller configured to control the switch circuit.
